(19) Europäisches Patentamt
European Patent Office
Office européen des brevets

(11) **EP 4 009 057 B1**

(12) **FASCICULE DE BREVET EUROPEEN**

(45) Date de publication et mention
de la délivrance du brevet:
**17.07.2024 Bulletin 2024/29**

(21) Numéro de dépôt: **21210841.9**

(22) Date de dépôt: **26.11.2021**

(51) Classification Internationale des Brevets (IPC):
**G01R 15/18** (2006.01)   **G01R 19/20** (2006.01)
**G01R 33/04** (2006.01)   **G01R 33/06** (2006.01)
**G01R 33/18** (2006.01)   **H01F 38/30** (2006.01)
**H01F 38/32** (2006.01)

(52) Classification Coopérative des Brevets (CPC):
**G01R 15/183; H01F 38/30; H01F 38/32;**
H01F 2038/305

(54) **DISPOSITIF DE MESURE DE COURANT ELECTRIQUE SANS CONTACT A NOYAU MAGNETIQUE FLEXIBLE**

KONTAKTLOSE STROMMESSVORRICHTUNG MIT FLEXIBLEM MAGNETKERN

CONTACTLESS DEVICE FOR MEASURING ELECTRIC CURRENT WITH FLEXIBLE MAGNETIC CORE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.11.2020 FR 2012196**

(43) Date de publication de la demande:
**08.06.2022 Bulletin 2022/23**

(73) Titulaire: **Chauvin Arnoux**
**92600 Asnieres-sur-Seine (FR)**

(72) Inventeur: **PION, Francisque**
**92600 ASNIERES-SUR-SEINE (FR)**

(74) Mandataire: **Cabinet Beau de Loménie**
**158, rue de l'Université**
**75340 Paris Cedex 07 (FR)**

(56) Documents cités:
**WO-A1-2009/153485    WO-A1-2019/135044**
**WO-A1-2020/002184    CN-U- 207 541 138**
**FR-A1- 2 710 753    FR-A1- 2 877 486**
**FR-A1- 2 891 917    FR-A1- 2 953 028**
**FR-A1- 2 983 966    FR-A1- 3 060 757**
**JP-A- H08 250 351**

**Description**

Domaine Technique

La présente invention se rapporte au domaine des mesures de courant sans contact et concerne plus particulièrement un dispositif de mesure de courant électrique comportant un noyau magnétique flexible.

Technique antérieure

Les capteurs de courant assurant une mesure sans contact sont bien connus, comme les capteurs à effet Hall, les capteurs de Rogowski, les magnétorésistances, les fluxgates (capteurs à porte de flux) ou encore les dispositifs magnéto-optiques. Certains, comme les capteurs de Rogowsky, sont particulièrement adaptés à la mesure de forts courants parce que d'une part leur sensibilité est faible (typiquement 1 $\mu$V/A/Hz, soit 50 mV pour un courant de 1 000 A à 50 Hz) et que d'autre part, ces capteurs ne saturent pas. D'autres, comme les capteurs à effet Hall, sont par contre moins sensibles et nécessitent l'adjonction d'un circuit magnétique pour concentrer le champ.

Toutefois, aucun de ces capteurs ne présente une souplesse suffisante pour être mis en oeuvre dans des environnements particulièrement contraints ou leur placement autour du conducteur dont on souhaite mesurer le courant le traversant peut alors s'avérer particulièrement difficile voire parfois impossible.

Les documents WO2009/153485A1, WO2020/002184A1, JP-H08-250351, FR2983966A1 et FR3060757A1 divulguent des capteurs de courant.

Exposé de l'invention

La présente invention a donc pour objet un dispositif de mesure de courant électrique sans contact particulièrement adapté à la mesure de faibles ou très faibles courants (typiquement inférieurs à 10 mA), comme les courants de fuite par exemple, et qui pallie les inconvénients précités par un noyau magnétique flexible et une électronique de traitement appropriée. Un but de l'invention est aussi d'obtenir un capteur qui permette des mesures de courants alternatifs aux fréquences industrielles (50/60 Hz), comme à des fréquences allant de 0,05Hz à 100KHz. Ces buts sont atteints par un dispositif de mesure de courant sans contact comme décrit dans la revendication 1.

Ainsi, avec un tel dispositif de mesure à noyau magnétique déformable, il est possible de former une boucle autour du conducteur qui s'adapte alors facilement à son environnement même particulièrement contraint et d'obtenir une mesure du courant en excluant la fréquence de polarisation du spectre de mesure (la bande passante du signal à traiter).

Avantageusement, le filtre de fréquence déterminée est un filtre passe-bas ou coupe-bande.

De préférence, le courant de polarisation à la fréquence de polarisation Fpol est obtenu en sortie d'un premier filtre passe-bas monté en sortie d'un générateur de signaux carrés et dont la fréquence de coupure est inférieure au premier harmonique 2Fpol de la fréquence de polarisation.

Selon le mode de réalisation envisagé, lorsque le signal de mesure est à 50/60Hz, la fréquence Fpol est comprise entre 133 et 333Hz, typiquement 166Hz, et la fréquence de coupure Fc du filtre passe-bas est comprise entre 2 et 30Hz, typiquement 16Hz. Lorsque le signal de mesure est à 1kHz, la fréquence Fpol est comprise entre 3,1 et 10,1kHz, typiquement 6,666kHz, et la fréquence de coupure Fc du filtre passe-bas est comprise entre 2 et 4,5kHz, typiquement 2,6kHz ou la fréquence de réjection du filtre coupe-bande est comprise entre 3,1 et 10,1kHz, typiquement 6,666kHz.

Avantageusement, ledit noyau magnétique déformable est formé de plusieurs dizaines de rubans magnétiques ayant chacun quelques dizaines de micromètres d'épaisseur.

De préférence, les rubans magnétiques sont constitués chacun de fer amorphe.

Avantageusement, le tube magnétique est à forte perméabilité relative, typiquement supérieure à 10000.

De préférence, les rubans magnétiques sont immobilisés à une de leurs deux extrémités ou en leur milieu.

Avantageusement, le noyau magnétique déformable est monté dans une gaine souple constituée de préférence en un matériau thermo-rétractable et isolée et lubrifiée pour supporter la déformation du noyau magnétique lors de l'encerclement du conducteur parcouru par le courant électrique à mesurer.

Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur les lesquels :

[Fig. 1] la figure 1 illustre schématiquement un dispositif de mesure de courant électrique sans contact selon l'invention,

[Fig. 2] la figure 2 montre une section du noyau magnétique du capteur flexible du dispositif de mesure de la figure 1,

[Fig. 3A-3B] les figures 3A-3B illustrent une position circulaire et une position déformée du capteur flexible de mesure,

[Fig. 4] la figure 4 illustre schématiquement un organe de fermeture de la boucle du capteur flexible de mesure, et

[Fig.5] la figure 5 détaille l'unité de traitement du dispositif de mesure de la figure 1.

Description des modes de réalisation

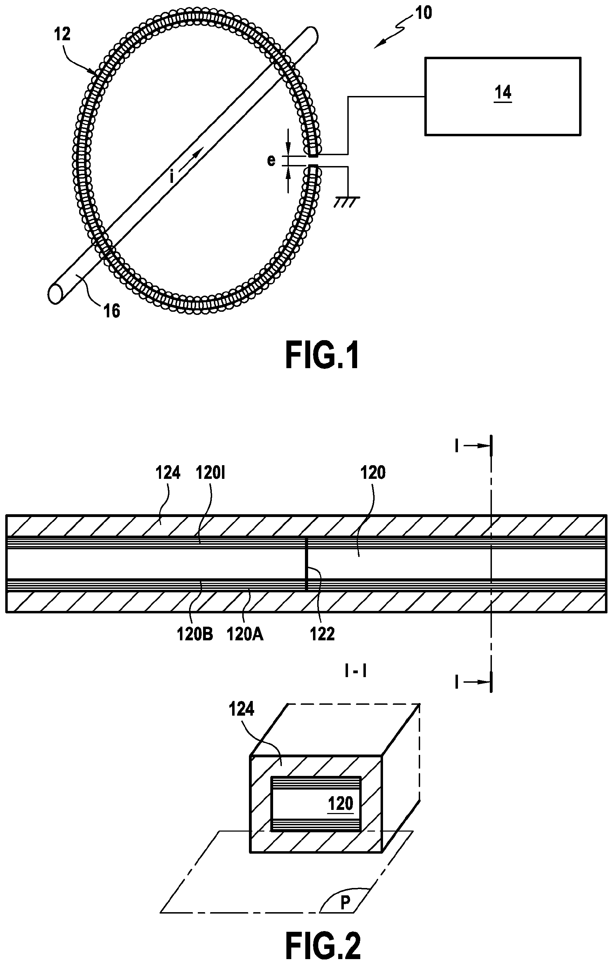

La figure 1 illustre le dispositif de mesure de courant électrique sans contact 10 selon l'invention comportant un capteur flexible 12 préférentiellement de forme toroïdale mais pas seulement, et un module électronique de traitement 14 pour traiter le signal de sortie du capteur et obtenir via un microprocesseur dédié ou un microcontrôleur la valeur du courant mesuré dans un conducteur 16 entouré par le capteur flexible 12.

Ce dispositif de mesure est très proche d'un capteur de Rogowski mais avec en plus un noyau magnétique. L'adjonction du noyau magnétique permet un gain très supérieur à 1000 aux très basses fréquences qui toutefois s'annule presque au centre de la courbe de magnétisation du matériau. L'objet de l'invention est notamment de corriger cette annulation.

Comme le montre la figure 2, le capteur flexible 12 comporte un noyau magnétique 120 constitué de fins rubans ou lamelles superposés 120A, 120B,..., 120I qui lui confère sa flexibilité selon le plan P formé par ces rubans magnétiques. Cet empilement est avantageusement formé de plusieurs dizaines de rubans magnétiques (typiquement entre 50 et 100) ayant chacun quelques dizaines de micromètres d'épaisseur (typiquement entre 20 et 50 microns), l'ensemble formant une pièce facilement déformable dans le plan P.

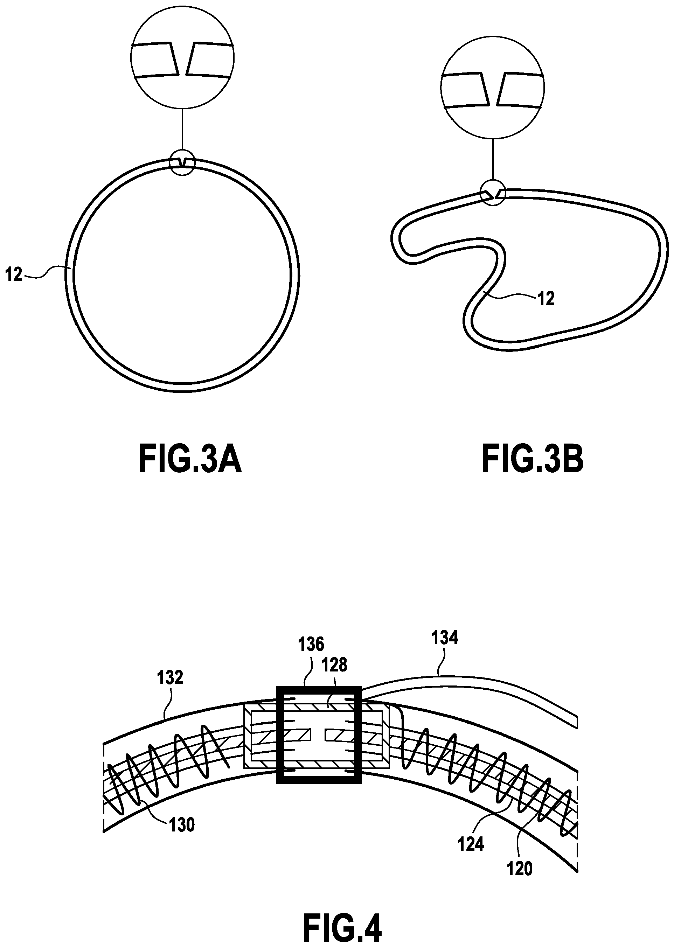

Les rubans sont empilés puis bloqués en un seul endroit 122 (ce blocage étant obtenu par soudage, brasage ou collage), par exemple au milieu comme illustré à la figure 2 ou à une extrémité. La déformation du noyau magnétique ainsi constitué se reporte sur les deux extrémités lorsque les rubans sont bloqués au centre ou sur l'extrémité restée libre en cas de blocage de l'autre extrémité. Les rubans sont maintenus ensemble dans une gaine souple isolante 124, avantageusement thermo-rétractable, et ils sont de préférence lubrifiés par de l'huile ou de la graisse (la nature du lubrifiant dépend des conditions de température d'utilisation), pour pouvoir supporter la déformation du noyau lors de l'encerclement du conducteur 16 parcouru par le courant électrique à mesurer et qui peut être d'accès difficile sauf à déformer de façon appropriée le capteur flexible (voir par exemple les figures 3A-3B comparant cette configuration déformée avec une configuration sans difficulté particulière d'encerclement). Certaines applications peuvent être incompatibles avec la présence de lubrifiant dans le capteur. Dans de tels cas, la gaine peut alors être surmoulée et avoir des propriétés de glissement à sec. Le matériau des rubans pourra avantageusement être du fer amorphe (METGLAS®).

Quelle que soit la configuration retenue pour le noyau magnétique 120 (on notera qu'une configuration avec des fils au lieu de rubans pourrait aussi garantir cette même flexibilité du noyau), se pose le problème de sa fermeture avec un minimum d'entrefer compris entre 1mm et quelques mm (typiquement 1 à 5mm) dont la saturation doit alors être maîtrisé. En effet, pour contrôler la saturation du matériau, il est nécessaire de disposer d'un entrefer à la fermeture du capteur flexible 12 autour du conducteur 16, la présence de cet entrefer permettant d'augmenter la valeur du champ de saturation et donc de linéariser le capteur (au prix toutefois d'une sensibilité réduite et d'une augmentation des champs parasites extérieurs au capteur).

La figure 4 illustre schématiquement l'organe permettant cette fermeture du capteur flexible. Cet organe de fermeture 126 comporte un tube magnétique 128 à forte perméabilité relative, typiquement supérieure à 10000, comme une ferrite ou tout autre matériau équivalent, dans lequel les deux extrémités du noyau magnétique sont emboîtées en laissant entre elles un entrefer e non nul. La gaine souple isolante 124 qui maintient en position l'empilement de rubans magnétiques 120 est entourée sur toute sa longueur d'un bobinage électrique 130, avantageusement à spires jointives formant ainsi un solénoïde, dont les deux extrémités traversent une gaine externe de protection souple 132 pour délivrer le signal de mesure de sortie pour l'unité de traitement 14 au niveau d'un câble de mesure 134 (dans l'exemple illustré le bobinage de mesure faisant un aller-retour sur la gaine les deux extrémités de sortie se retrouvent d'un même côté de la gaine). Un boîtier externe 136 assure la protection de la ferrite tout en permettant l'ouverture de la boucle de mesure.

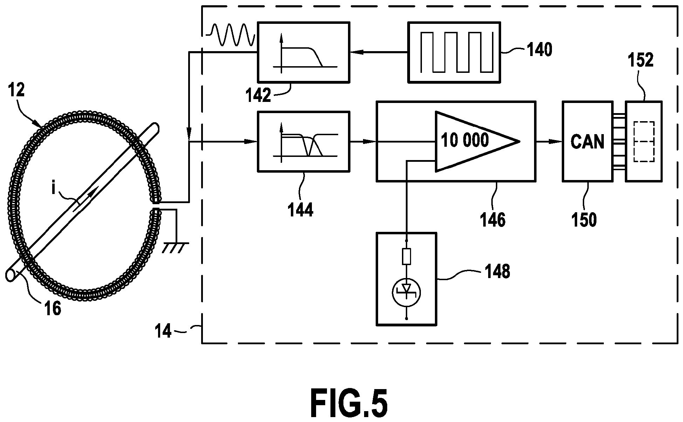

L'unité de traitement est illustrée à la figure 5 qui en donne un schéma de principe simplifié. Elle comporte un générateur de signaux carrés 140 dont la sortie est reliée à un filtre passe-bas 142 dont la fréquence de coupure comprise entre la fondamentale Fpol et le premier harmonique 2Fpol permet d'écarter les harmoniques et d'obtenir en sortie un parfait signal sinusoïdal. De façon alternative, ce signal sinusoïdal pourrait aussi être obtenu directement depuis un quartz ou tout autre dispositif oscillant par exemple. Le signal sinusoïdal est injecté dans le bobinage électrique 130 qui délivre le signal de sortie (signal de mesure) du capteur flexible pour un filtre de fréquence déterminée 144 dont la sortie est reliée à un amplificateur à grand gain 146, typiquement 10000, dont le zéro (son point de repos) est décalé par une source de tension 148. Le signal amplifié délivré en sortie de l'amplificateur constitue le signal d'entrée pour un microprocesseur ou microcontrôleur 150 (ou autre composant équivalent tel que ASIC ou FPGA par exemple) qui assure une conversion analogique-numérique du signal amplifié et son traitement pour délivrer une valeur de courant. La valeur de courant ainsi déterminée peut être convertie en valeur efficace et affichée sur un afficheur 152 (d'autres paramètres du courant comme la fréquence et la valeur moyenne continue peuvent éventuellement aussi être affichées). Bien entendu, cette unité de traitement est alimentée par une batterie (non représentée), rechargeable ou non, typiquement de 5V, dont le niveau de charge peut aussi être visualisé sur l'afficheur. En liaison avec le microcontrôleur 150, cet afficheur peut aussi afficher un certain nombre d'autres états permettant de vérifier le bon fonctionnement du dispositif de mesure.

Le fonctionnement du dispositif de mesure de courant peut se résumer comme suit.

Le noyau magnétique 120 décrit précédemment est entouré du bobinage électrique de mesure 130 sur toute sa longueur. Lorsque le capteur flexible 12 est refermé autour du conducteur d'intérêt 16 parcouru par un courant 1 de fréquence F, le bobinage de mesure est le siège d'une force électromotrice induite dont l'amplitude est proportionnelle à l'amplitude du courant et à sa fréquence.

En application des lois de Faraday et Ampère :

$$v(t) = -\frac{\mu_0\,\mu_r\,N\,S}{l}\,\frac{di(t)}{dt}$$

$\mu_0$ = perméabilité magnétique du vide

$\mu_r$ = perméabilité magnétique du matériau

N = nombre de spires

S = section du bobinage

l = longueur du bobinage

i(t) = courant générant le champ traversant le bobinage

Le rôle de l'unité de traitement 14 est d'amplifier ce signal et de l'égaliser en fréquence afin d'obtenir une bande passante plate dans le domaine de fréquence considéré. Or, la présente invention a pour objet la mesure de très faibles courants alternatifs (quelques mA) et pour des valeurs aussi faibles, la courbe de magnétisation du matériau magnétique (diagramme B-H) n'est pas linéaire.

Ainsi, si on considère la structure à une échelle intermédiaire entre l'ensemble du cristal et l'échelle atomique d'un monocristal de fer, pratiquement sans défauts, c'est-à-dire celle des domaines magnétiques dits de Weiss, on peut constater que dès que l'on applique un champ H dans une direction déterminée, l'énergie des moments magnétiques est augmentée dans les domaines ayant une direction opposée, et dans une plus faible mesure, dans le domaine central de Weiss. Le respect de la condition de l'énergie minimum dans l'échantillon entraîne alors une diminution du volume de ces domaines. Dans un champ H croissant, la structure des domaines se transformera progressivement jusqu'à finalement ne plus présenter qu'un seul domaine orienté selon H.

Dans cet exemple idéal, le déplacement des parois de Bloch qui sont les interfaces de séparation entre deux domaines magnétiques de Weiss d'orientations différentes est parfaitement libre et en coupant le champ H, on retrouve l'état initial de la structure, le processus de polarisation étant réversible.

Or, les défauts cristallins ont un effet important sur la forme du diagramme B-H. L'action de défauts ponctuels sur le déplacement des parois de Bloch, à l'intérieur d'un monocristal, a été étudiée et l'expérience de Barkhausen a mise en évidence des mouvements irréversibles de ces parois qui se déplacent par une série de sauts qui font céder les points d'épinglage des parois.

Conformément à l'invention, le phénomène des sauts de Barkhausen précité est compensé par la mise en oeuvre d'une polarisation magnétique.

Pour ce faire, dans l'unité de traitement 14, un courant de polarisation alternatif de fréquence de polarisation Fpol supérieure à la limite haute de la bande passante utile et d'amplitude supérieure à celle du courant i à mesurer est ajouté dans le bobinage de mesure 130. Le champ de polarisation ainsi créé fait que le point de repos magnétique n'est plus stationnaire au centre de la courbe de magnétisation mais qu'il se déplace en permanence au rythme du courant de polarisation ainsi créé. Idéalement, si le rapport des fréquences entre la fréquence de polarisation et la fréquence de mesure est suffisamment élevé (c'est-à-dire supérieur à 2,5), chaque valeur du champ de mesure parcours un ou plusieurs cycles de magnétisation / démagnétisation à la fréquence de polarisation Fpol et à une amplitude moyenne correspondant à l'amplitude du courant de polarisation. Comme le champ provoqué par le courant de mesure est additionné, tout se passe comme si le courant de mesure était beaucoup plus magnétisant qu'il ne l'est en réalité faisant sortir la fonction de transfert de la zone centrale non linéaire. Le filtrage de fréquence approprié 144 (passe-bas mais qui pourrait être aussi coupe-bande) élimine ensuite le signal à la fréquence de polarisation Fpol pour ne conserver que celle du signal de mesure.

Le choix de la fréquence de coupure de ce filtre relève d'un calcul d'optimisation consistant à éliminer la composante de sortie à la fréquence de polarisation au moindre coût. Tout d'abord, du fait de la grande amplitude du signal de polarisation comparée à l'amplitude du signal utile, il est recouru à un filtre analogique. En outre, la fréquence de polarisation étant choisie au-delà de la bande passante utile, il y a donc avant filtrage une très forte prépondérance du signal de polarisation par rapport au signal utile dans un rapport pouvant être de 50000/1 par exemple.

Ainsi, lorsque le signal de mesure F est à 50/60 Hz, la fréquence Fpol non multiple de la fréquence de mesure peut être comprise entre 133 et 333Hz, typiquement 166Hz, et la fréquence Fc du filtre passe-bas peut être comprise entre 2 et 30Hz, typiquement 16Hz. Lorsque le signal de mesure F est à 1kHz, la fréquence Fpol non multiple de la fréquence de mesure peut être comprise entre 3,1 et 10,1kHz, typiquement 6,666kHz, et la fréquence Fc du filtre passe-bas peut être comprise entre 2 et 4,5kHz, typiquement 2,6KHz ou encore la fréquence de réjection du filtre coupe-bande peut être compris entre 3,1 et 10, 1kHz, typiquement 6,666kHz.

On notera que le recours dans l'unité de traitement 14 à un convertisseur analogique numérique à très grande dynamique (18 à 24 bits) peut permettre de substituer au filtrage de fréquence 144 un filtrage passe bas numérique. Cette configuration présente alors l'intérêt de permettre d'adopter un mode de fonctionnement dans lequel la fréquence de polarisation est en permanence calculée par le processeur pour être non multiple du fondamental du signal utile mesuré. En effet, dans certaines applications, la fréquence du signal utile peut être quelconque et comprise dans une large bande passante. Il peut alors devenir délicat de choisir à l'avance la fréquence de polarisation sans tomber sur un multiple pris dans l'intervalle d'intérêt de la fréquence à mesurer.

En pratique, la fréquence de polarisation magnétique peut être choisie arbitrairement plus grande que le spectre de mesure et l'éliminer par un filtrage passe bas. Dans tous les cas, on peut aussi utiliser un filtrage par réjection dès l'instant que la fréquence de polarisation ne fait pas partie de ce spectre de mesure.

## Revendications

1. Dispositif (10) de mesure de courant alternatif sans contact comportant un capteur flexible (12) et une unité de traitement (14), le capteur flexible entourant un conducteur (16) parcouru par un courant électrique à mesurer d'amplitude inférieure à 10mA et ayant un noyau magnétique déformable (120), dispositif dans lequel l'unité de traitement est configurée pour, dans un bobinage de mesure (130), ajouter à un courant de mesure à une fréquence F un courant de polarisation à une fréquence de polarisation Fpol non multiple et au moins 2,5 fois supérieure à cette fréquence F et de grande amplitude supérieure à l'amplitude du courant de mesure puis, au moyen d'un filtre de fréquence déterminée (144), éliminer ce courant de polarisation à la fréquence de polarisation Fpol pour ne conserver que le courant de mesure à la fréquence F.

2. Dispositif de mesure selon la revendication 1, **caractérisé en ce que** le filtre de fréquence déterminée (144) est un filtre passe-bas ou coupe-bande.

3. Dispositif de mesure selon la revendication 2, **caractérisé en ce que** le courant de polarisation à la fréquence de polarisation Fpol est obtenu en sortie d'un filtre passe-bas (142) monté en sortie d'un générateur de signaux carrés (140) et dont la fréquence de coupure est inférieure au premier harmonique 2Fpol de la fréquence de polarisation.

4. Dispositif de mesure selon la revendication 2, **caractérisé en ce que**, lorsque le signal de mesure est à 50/60Hz, la fréquence Fpol est comprise entre 133 et 333Hz, typiquement 166Hz, et la fréquence de coupure Fc du filtre passe-bas est comprise entre 2 et 30Hz, typiquement 16Hz.

5. Dispositif de mesure selon la revendication 2, **caractérisé en ce que**, lorsque le signal de mesure est à 1kHz, la fréquence Fpol est comprise entre 3,1 et 10,1kHz, typiquement 6,666kHz, et la fréquence de coupure Fc du filtre passe-bas est comprise entre 2 et 4,5kHz, typiquement 2,6kHz ou la fréquence de réjection du filtre coupe-bande est comprise entre 3,1 et 10,1kHz, typiquement 6,666kHz.

6. Dispositif de mesure selon la revendication 1, **caractérisé en ce que** l'unité de traitement est configurée pour calculer la fréquence de polarisation Fpol de façon à être en permanence non multiple de la fréquence F.

7. Dispositif de mesure selon la revendication 1, **caractérisé en ce que** ledit noyau magnétique déformable est formé de plusieurs dizaines de rubans magnétiques (120A - 120I) ayant chacun quelques dizaines de micromètres d'épaisseur et dont les deux extrémités sont destinées à être emboîtées dans un tube magnétique (128) d'un organe de fermeture (126) en laissant entre elles un entrefer e non nul.

8. Dispositif de mesure selon la revendication 5, **caractérisé en ce que** les rubans magnétiques (120A - 120I) sont constitués chacun de fer amorphe.

9. Dispositif de mesure selon la revendication 5, **caractérisé en ce que** le tube magnétique (128) est à forte perméabilité relative, typiquement supérieure à 10000.

10. Dispositif de mesure selon l'une quelconque des revendications 5 à 9, **caractérisé en ce que** les rubans magnétiques (120A - 120I) sont immobilisés à une de leurs deux extrémités ou en leur milieu.

11. Dispositif de mesure selon l'une quelconque des revendications 5 à 10, **caractérisé en ce que** le noyau magnétique déformable est monté dans une gaine souple (124) isolée et lubrifiée pour supporter la déformation du noyau magnétique (120) lors de l'encerclement du conducteur (16) parcouru par le courant électrique à mesurer.

12. Dispositif de mesure selon la revendication 11, **caractérisé en ce que** la gaine souple (124) est constituée en un matériau thermo-rétractable.

**Patentansprüche**

1. Vorrichtung (10) zur kontaktlosen Messung von Wechselstrom, die einen flexiblen Sensor (12) und eine Verarbeitungseinheit (14) beinhaltet, wobei der flexible Sensor einen Leiter (16) umgibt, der von einem zu messenden elektrischen Strom mit einer Amplitude von weniger als 10 mA durchflossen wird, und einen verformbaren magnetischen Kern (120) aufweist, wobei in der Vorrichtung die Verarbeitungseinheit dazu ausgestaltet ist, in einer Messspule (130) zu einem zu messenden Strom mit einer Frequenz F einen Vorspannungsstrom mit einer Vorspannungsfrequenz Fpol, die kein Vielfaches und zumindest 2,5 mal höher als diese Frequenz F ist, und mit einer größeren Amplitude als die Amplitude des zu messenden Stroms hinzuzufügen, anschließend mittels eines Filters für eine bestimmte Frequenz (144) diesen Vorspannungsstrom mit der Vorspannungsfrequenz Fpol zu eliminieren, um nur den zu messenden Strom mit der Frequenz F zu erhalten.

2. Vorrichtung zur Messung nach Anspruch 1, **dadurch gekennzeichnet, dass** der Filter für die bestimmte Frequenz (144) ein Tiefpass- oder Bandsperrfilter ist.

3. Vorrichtung zur Messung nach Anspruch 2, **dadurch gekennzeichnet, dass** der Vorspannungsstrom mit der Vorspannungsfrequenz Fpol am Ausgang eines Tiefpassfilters (142) erhalten wird, der am Ausgang eines Rechtecksignal-Generators (140) montiert ist und dessen Grenzfrequenz niedriger ist als die erste Harmonische 2Fpol der Vorspannungsfrequenz.

4. Vorrichtung zur Messung nach Anspruch 2, **dadurch gekennzeichnet, dass**, wenn das Messsignal bei 50/60 Hz liegt, die Frequenz Fpol zwischen 133 und 333 Hz, in der Regel bei 166 Hz, liegt und die Grenzfrequenz Fc des Tiefpassfilters zwischen 2 und 30 Hz, in der Regel bei 16 Hz, liegt.

5. Vorrichtung zur Messung nach Anspruch 2, **dadurch gekennzeichnet, dass**, wenn das Messsignal bei 1 kHz liegt, die Frequenz Fpol zwischen 3,1 und 10,1 kHz, in der Regel bei 6,666 kHz, liegt und die Grenzfrequenz Fc des Tiefpassfilters zwischen 2 und 4,5 kHz, in der Regel bei 2,6 kHz, liegt oder die Sperrfrequenz des Bandsperrfilters zwischen 3,1 und 10,1 kHz, in der Regel bei 6,666 kHz, liegt.

6. Vorrichtung zur Messung nach Anspruch 1, **dadurch gekennzeichnet, dass** die Verarbeitungseinheit dazu ausgestaltet ist, die Vorspannungsfrequenz Fpol so zu berechnen, dass sie permanent kein Vielfaches der Frequenz F ist.

7. Vorrichtung zur Messung nach Anspruch 1, **dadurch gekennzeichnet, dass** der verformbare magnetische Kern aus mehreren zehn magnetischen Streifen (120A - 120I) gebildet wird, die jeweils einige zehn Mikrometer Dicke aufweisen und deren zwei Enden dazu bestimmt sind, in ein magnetisches Rohr (128) eines Verschlussorgans (126) gesteckt zu werden, wobei zwischen ihnen ein Spalt e ungleich null verbleibt.

8. Vorrichtung zur Messung nach Anspruch 5, **dadurch gekennzeichnet, dass** die magnetischen Streifen (120A - 120I) jeweils aus amorphem Eisen gebildet sind.

9. Vorrichtung zur Messung nach Anspruch 5, **dadurch gekennzeichnet, dass** das magnetische Rohr (128) eine starke relative Permeabilität, in der Regel von mehr als 10.000, aufweist.

10. Vorrichtung zur Messung nach einem der Ansprüche 5 bis 9, **dadurch gekennzeichnet, dass** die magnetischen Streifen (120A - 120I) an einem ihrer zwei Enden oder in ihrer Mitte festgesetzt sind.

11. Vorrichtung zur Messung nach einem der Ansprüche 5 bis 10, **dadurch gekennzeichnet, dass** der verformbare magnetische Kern in einer flexiblen, isolierten und geschmierten Hülle (124) montiert ist, um die Verformung des magnetischen Kerns (120) bei der Umschließung des Leiters (16), der von dem zu messenden elektrischen Strom durchflossen wird, zu unterstützen.

12. Vorrichtung zur Messung nach Anspruch 11, **dadurch gekennzeichnet, dass** die flexible Hülle (124) aus einem wärmeschrumpfbaren Material gebildet ist.

**Claims**

1. A device (10) for measuring a non-contact alternating current including a flexible sensor (12) and a processing unit (14), the flexible sensor surrounding a conductor (16) traversed by an electric current to be measured with an amplitude less than 10mA and having a deformable magnetic core (120), device in which the processing unit is configured, in a measuring winding (130), to add to a measuring current at a frequency F a bias current at a non-multiple bias frequency Fpol and at least 2.5 times greater than this frequency F and of large amplitude greater than the amplitude of the measurement current then, by means of a determined frequency filter (144), to eliminate this bias current at the bias frequency Fpol to maintain only the measurement current at the frequency F.

2. The measuring device according to claim 1, **characterized in that** the determined frequency filter (144) is a low-pass or band-stop filter.

3. The measuring device according to claim 2, **characterized in that** the bias current at the bias frequency Fpol is obtained at the output of a low-pass filter (142) mounted at the output of a square signal generator (140) and whose cutoff frequency is lower than the first harmonic 2Fpol of the bias frequency.

4. The measuring device according to claim 2, **characterized in that**, when the measurement signal is at 50/60Hz, the frequency Fpol is comprised between 133 and 333Hz, typically 166Hz, and the cutoff frequency Fc of the low-pass filter is comprised between 2 and 30Hz, typically 16Hz.

5. The measuring device according to claim 2, **characterized in that**, when the measurement signal is at 1kHz, the frequency Fpol is comprised between 3.1 and 10.1kHz, typically 6.666kHz, and the cutoff frequency Fc of the low-pass filter is comprised between 2 and 4.5kHz, typically 2.6kHz or the rejection frequency of the band-stop filter is comprised between 3.1 and 10.1kHz, typically 6.666kHz.

6. The measuring device according to claim 1, **characterized in that** the processing unit is configured to calculate the bias frequency Fpol so as to be permanently non-multiple of the frequency F.

7. The measuring device according to claim 1, **characterized in that** said deformable magnetic core is formed of several tens of magnetic strips (120A - 120I) each being a few tens of micrometers thick and two ends of which are intended to be interlocked into a magnetic tube (128) of a closing member (126) leaving a non-zero air gap therebetween.

8. The measuring device according to claim 5, **characterized in that** the magnetic strips (120A - 120I) each consist of amorphous iron.

9. The measuring device according to claim 5, **characterized in that** the magnetic tube (128) has a high relative permeability, typically greater than 10,000.

10. The measuring device according to any one of claims 5 to 9, **characterized in that** the magnetic strips (120A - 120I) are immobilized at one of their two ends or in their middle.

11. The measuring device according to any one of claims 5 to 10, **characterized in that** the deformable magnetic core is mounted in a flexible sheath (124) insulated and lubricated to support the deformation of the magnetic core (120) during the encirclement of the conductor (16) traversed by the electric current to be measured.

12. The measuring device according to claim 11, **characterized in that** the flexible sheath (124) is made of a heat-shrinkable material.

**FIG.1**

I - I

**FIG.2**

**FIG.3A**

**FIG.3B**

**FIG.4**

**FIG.5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009153485 A1
- WO 2020002184 A1
- JP H08250351 B
- FR 2983966 A1
- FR 3060757 A1